# EUROPÄISCHE PATENTSCHRIFT

(11) **EP 2 567 601 B1**
(45) Veröffentlichungstag und Bekanntmachung des Hinweises auf die Patenterteilung: **12.03.2014**
(21) Anmeldenummer: 11723862.6
(22) Anmeldetag: 23.03.2011
(51) Int. Cl.: H05K 3/02, B23K 26/36

(54) **VERFAHREN ZUM PARTIELLEN LÖSEN EINER DEFINIERTEN FLÄCHE EINER LEITFÄHIGEN SCHICHT**
METHOD FOR PARTIALLY STRIPPING A DEFINED AREA OF A CONDUCTIVE LAYER
PROCÉDÉ DE DISSOLUTION PARTIELLE D'UNE SURFACE DÉFINIE D'UNE COUCHE CONDUCTRICE

(30) Priorität: 04.05.2010 DE 102010019406
(43) Veröffentlichungstag der Anmeldung: 13.03.2013
(73) Patentinhaber: LPKF Laser & Electronics AG, 30827 Garbsen (DE)
(72) Erfinder: VAN AALST, Jan, 30890 Barsinghausen (DE); KOVACIC, Drago, 9240 Ljutomer (SI); PODOBNIK, Bostjan, 1000 Ljubljana (SI)
(74) Vertreter: Scheffler, Jörg
(86) Internationale Anmeldenummer: PCT/DE2011/075047
(87) Internationale Veröffentlichungsnummer: WO 2011/137896

(56) Entgegenhaltungen:
- WO-A1-2005/076678
- JP-A- 4 116 887
- US-A1- 2007 130 754
- US-A1- 2008 083 706

## Beschreibung

Die Erfindung betrifft ein Verfahren zum partiellen Lösen einer definierten Fläche einer leitfähigen Schicht, insbesondere einer Kupferschicht, unter Aussparung einer Leiterbahn mittels eines Laserstrahls, wobei auf einem Substrat eine Leiterbahn mit einem bestimmten Verlauf aus der leitfähigen Schicht ausgebildet wird und wobei die Laserstrahlparameter derart eingestellt werden, dass lediglich die leitfähige Schicht abgetragen wird, ohne dass dabei zugleich auch das darunterliegende, die leitfähige Schicht tragende Substrat beeinträchtigt wird, wobei die Fläche zunächst in Bereiche unterteilt wird, die jeweils in ihrem äußeren Randbereich gegenüber den angrenzenden Bereichen der leitfähigen Schicht durch Einbringen einer linienförmigen Ausnehmung entlang eines jeweiligen Umfangs der Bereiche thermisch isoliert werden, und anschließend ein abzutragender Bereich mittels Laserstrahlung erwärmt wird, bis die Adhäsion der leitfähigen Schicht auf dem Substrat wesentlich verringert ist und der abzutragende Bereich von dem Substrat unter äußeren Einwirkungen flächig abgelöst wird.

Ein solches Verfahren zum partiellen Lösen bzw. Abtragen einer leitfähigen Schicht von einem beispielsweise flexiblen oder polymeren, insbesondere auch dreidimensionalen Schaltungsträger oder von einer konventionellen Leiterplatte ist beispielsweise durch die DE 10 2004 006 414 B4 bekannt und wird in der Praxis insbesondere dann eingesetzt, wenn ein chemisches Abtragen der gewünschten Fläche nicht möglich oder unerwünscht ist, beispielsweise im Bereich der Prototypenfertigung.

Das Abtragen einer leitfähigen Schicht mittels Laserstrahlung ist dadurch bereits grundsätzlich bekannt. Sofern die Materialeigenschaften des Substrats gegenüber der leitfähigen Schicht insbesondere hinsichtlich der jeweils erforderlichen Laserablationsgrenzwerte oder auch der Schmelzpunkte höhere Grenzwerte aufweisen, können die Laserparameter derart eingestellt werden, dass lediglich die leitfähige Schicht durch den Laserstrahl entfernt wird, während das Substrat nicht beschädigt oder beeinträchtigt wird. Hierzu wird der abzutragende Bereich mittels eines Laserstrahls erwärmt. Die abzutragende Fläche besteht aus einzelnen Bereich en, die eine streifenförmige Gestalt aufweisen können, wobei die sie begrenzenden Ausnehmungen im Wesentlichen entlang paralleler Geraden verlaufen.

Die US 3,214,315 betrifft ein Verfahren, bei dem die Leiterbahn durch einen Stempel mechanisch von der abzulösenden Fläche getrennt wird, wobei der Stempel erwärmt wird, um eine geringe Haftung der Fläche auf dem Substrat zu erreichen. Nach dem Entfernen der Fläche dient ein weiterer Wärmeeintrag der Aushärtung des Substrats und damit der dauerhaften Verbindung der Leiterbahnen mit dem Substrat.

Aus der EP 0 834 191 B1 ist ein Verfahren zum Laserabtrag von leitfähigen Schichten durch Verminderung der Adhäsion zwischen Leitschicht und Trägersubstrat bekannt. Ähnliche Verfahren werden auch in der US 2003/0047280 A1 sowie der JP 2003-47841 A beschrieben.

Die US 2001/006766 A1 offenbart ein Verfahren, bei dem mittels einer elektromagnetischen Strahlung durch die Oberfläche der Fläche hindurch die Verbindung zwischen der Fläche und dem Substrat geschwächt wird, um in diesen Bereichen anschließend die Fläche zu lösen. Der Vorteil liegt in dem hierzu reduzierten Energieeintrag, der im Vergleich zu der Ablationsenergie der Schicht gering ist.

Die DE 694 11 337 T2 lehrt ein Verfahren zur Herstellung einer leitfähigen Schaltung auf einem Formteil aus Harz, wobei ein aufgebrachter Metallfilm mit Laserstrahlung entlang der Grenzen eines Anteils, der in der leitfähigen Schicht gebildet werden soll, bestrahlt wird, um den bestrahlten Metallfilm zu entfernen. Der für die Schaltung nicht benötigte Anteil des Metallfilms wird durch chemisches Ätzen entfernt.

Ferner ist aus der US 2002/0106522 A1 ein Verfahren zum Entfernen einer leitfähigen Schicht von einem dielektrischen Substrat bekannt, bei dem zunächst entlang der Begrenzungslinie des zu entfernenden Bereichs der leitfähigen Schicht ein Schnitt mit einem Laserstrahl vorgenommen wird und anschließend die leitfähige Schicht abgezogen wird.

Die WO 90/09730 A1 lehrt ein Verfahren zur Herstellung einer Elektrodenstruktur aus einer Schicht aus elektrisch leitfähigem Material auf einem isolierenden Substrat durch einen Laserstrahl, wobei die Elektroden streifenförmige Gestalt haben. Die Entfernung erfolgt mittels Druckluft oder Absaugung. US 2008/083 706 beschreibt ein weiteres Laser-ablations verfahren aus dem Stand der Technik.

Besondere Anforderungen sind bei der Durchführung des Verfahrens an die Unterteilung der abzutragenden Fläche in einzelne Bereiche zu stellen. Hierzu wird die Fläche oftmals in Streifen vorbestimmter Breite unterteilt, die im Hinblick auf den nachfolgend einzubringenden thermischen Energieeintrag zum schnellen Ablösen der Fläche optimiert sind. Als hinderlich erweist es sich in der Praxis, dass oftmals zumindest ein Streifen, der an die Leiterbahn oder einen Rand angrenzt, nicht die optimale Breite aufweist, also einen geringeren Flächeninhalt besitzt. Um hier nicht Gefahr zu laufen, dass die thermische Energie zu groß ist und es dadurch zu einer Schädigung der angrenzenden Leiterbahn kommt, wird oftmals auf die der Leiterbahn benachbarte Ausnehmung verzichtet und der entsprechend vergrößerte Bereich separat entfernt. Hierdurch kommt es zu einem unerwünschten Nachbearbeitungsaufwand.

Es ist auch bereits daran gedacht worden, die zu unterteilende Fläche in Streifen gleicher Breite aufzuteilen, deren Verlauf parallel zu einer Haupterstreckung der Leiterbahnen gewählt wird. Allerdings verlaufen die Leiterbahnen in der Praxis im Allgemeinen nicht nur in einer Richtung. Zudem variiert die Breite der Leiterbahnen. In der Folge kommt es also dennoch zu unterschiedlichen Breiten der streifenförmigen Bereiche, sodass der thermische Energieeintrag für diese verbleibenden Bereiche abweichender Größe individuell eingestellt werden oder ein manueller Abtrag erfolgen müsste.

Ausgehend von diesem Stand der Technik liegt der Erfindung die Aufgabe zugrunde, das Verfahren weiter zu optimieren. Insbesondere soll eine vorteilhafte Einteilung der Bereiche vorgeschlagen werden, durch welche der flächige Abtrag weiter verbessert und eine Schädigung angrenzender Leiterbahnen vermieden wird.

Diese Aufgabe wird erfindungsgemäß mit einem Verfahren gemäß den Merkmalen des Anspruchs 1 gelöst. Die weitere Ausgestaltung der Erfindung ist den Unteransprüchen zu entnehmen.

Erfindungsgemäß ist also ein Verfahren zum partiellen Lösen einer definierten Fläche einer leitfähigen Schicht vorgesehen, bei dem die Bereiche streifenförmig ausgebildet werden, sodass die Ausnehmungen im Wesentlichen entlang von Geraden verlaufen, deren Verlauf so gewählt wird, dass diese zu keiner der durch den bekannten Verlauf der Leiterbahnen bestimmten Hauptachsen parallel verlaufen. Indem die abzutragende Fläche in Streifen vorbestimmter, insbesondere im Hinblick auf den nachfolgenden thermischen Energieeintrag optimierter Breite unterteilt wird, wobei die Orientierung der die Bereiche unterteilenden Ausnehmung als Trennlinie abweichend von den Hauptachsen der Leiterbahnen gewählt wird, ist ein paralleler Verlauf zu einer Leiterbahn in der Praxis äußerst unwahrscheinlich. Vielmehr schließen die Ausnehmungen mit der jeweiligen Leiterbahn jeweils einen spitzen Winkel ein. Vorzugsweise könnte auch zunächst der bekannte Verlauf der Leiterbahnen erfasst und ein Winkelverlauf der Ausnehmungen festgelegt werden, welcher von allen erfassten Orientierungen der Leiterbahnen abweicht, insbesondere eine maximale Abweichung aufweist. Die Erfindung macht sich dabei zunutze, dass die Leiterbahnen im Allgemeinen in Richtung der X- oder Y- Achse oder unter einem 45°-Winkel zu diesen verläuft. Ein abweichender Winkel führt dazu, dass die Ausnehmungen stets in einem spitzen Winkel auf die Leiterbahn treffen, also nie parallel laufen, sodass diese als Ganzes entfernt werden können. Der erfindungsgemäße Vorteil besteht nun darin, dass durch die so bestimmte Orientierung der Ausnehmungen ein paralleler Verlauf zu den Leiterbahnen und somit ein paralleler thermischer Energieeintrag zum Einbringen der Ausnehmung zur Unterteilung der benachbarten Bereiche vermieden wird, sodass ein unerwünschter Energieeintrag in die Leiterbahn wesentlich vermindert und eine Schädigung desselben ausgeschlossen werden kann.

Zudem konvergieren die Endbereiche jedes streifenförmigen Bereichs, sodass also die Breite im Endbereich vermindert ist. Die zum Ablösen erforderliche thermische Energie ist somit ebenfalls reduziert, sodass der thermische Energieeintrag zumindest in dem Endbereich benachbart zu einer Leiterbahn vermindert werden kann. Beispielsweise kann der Laser für den thermischen Energieeintrag stets einen ausreichenden Abstand zu der Leiterbahn einhalten, ohne dass die Ablösung des Endbereichs erschwert wird. Vielmehr nähert sich der Laser bei der Erwärmung des Bereichs zwar der Leiterbahn an, verläuft aber nie parallel zu dieser.

Auch die gegebenenfalls entstehenden dreieckigen Bereiche können einfach separat entfernt werden, weil hierzu lediglich ein geringer Wärmeeintrag erforderlich ist, der zudem ebenfalls nicht parallel zu der Leiterbahn erfolgt.

Bei einer besonders vorteilhaften Ausgestaltung des Verfahrens schließen die Ausnehmungen sowohl mit den Hauptachsen als auch mit den Winkelhalbierenden der Hauptachsen einen spitzen Winkel ein und verlaufen in einem Winkel zwischen 10° und 35°, insbesondere zwischen 20° und 25°, zu einer Hauptachse. Hierdurch kann in der Praxis auch ohne vorhergehende Überprüfung der Orientierung der Leiterbahnen erreicht werden, dass ein zu den Hauptachsen sowie zu deren Winkelhalbierenden paralleler Verlauf zumindest nahezu ausgeschlossen ist. Beispielsweise eignet sich hierzu in der Praxis ein Winkel von 22,5° zwischen den Ausnehmungen und einer Hauptachse oder einer Winkelhalbierenden.

Weiterhin hat sich in der Praxis bereits eine Weiterbildung als besonders Erfolg versprechend erwiesen, bei welcher die Ausnehmungen eines Bereichs mit Ausnahme der jeweiligen Endbereiche parallel zueinander verlaufen und die Bereiche dabei vorzugsweise eine einheitliche Breite aufweisen. Hierdurch wird nicht nur die Unterteilung der Bereiche vereinfacht, sondern auch ein optimaler Wärmeeintrag und damit eine schnelle sowie eine zuverlässige Herabsetzung der Adhäsionskräfte erreicht. Auf diese Weise wird ein großflächiger Abtrag der zu lösenden Schicht bei minimalem Zeitaufwand erreicht.

Dabei ist es besonders sinnvoll, wenn die Ausnehmungen in einem Endbereich mit einer der Leiterbahn zugewandten Abwinkelung oder Biegung in einem Winkel von insbesondere 90° zu der Leiterbahn eingebracht werden, um so sehr kleine Winkel zwischen der Ausnehmung und der Leiterbahn, die zu einem Aufschmelzen und Einbrennen in das Substrat führen können, zu vermeiden. Bei einer Annäherung an die Leiterbahn verläuft die Ausnehmung mit einer Kurve oder einem Knick im 90°-Winkel auf die Leiterbahn zu.

Die Fläche könnte bei entsprechender Eignung der leitfähigen Schicht mittels magnetischer oder elektrostatischer Kräfte abgetragen werden. Besonders vorteilhaft ist hingegen eine Abwandlung, bei der die erwärmte Fläche mittels einer gezielten Druckluftzufuhr von dem Substrat getrennt wird, wobei ein gezielter Druckluftstrahl ein Abheben der leitfähigen Schicht beginnend vom Rand zur Mitte der Fläche ermöglicht.

Weiterhin ist es auch Erfolg versprechend, wenn die erwärmte Fläche durch Absaugen von dem Substrat getrennt wird. Dadurch wird verhindert, dass sich erwärmte, abgelöste Teile auf dem Substrat an anderer Stelle absetzen und durch die in ihnen gespeicherte thermische Energie das Substrat an dieser Stelle so weit anschmelzen können, dass sie daran haften bleiben.

Dabei wird die Richtung der Fluidströmung vorzugsweise derart eingestellt, dass diese zu den geraden Ausnehmungen weder parallel noch orthogonal verlaufen. Ausgehend von dem bestimmten Verlauf der zuvor eingebrachten Ausnehmungen erfolgt so in dem nachfolgenden Arbeitsgang der Abtrag der durch Laserenergie erwärmten streifenförmigen Bereiche indem die Adhäsion der leitfähigen Schicht auf dem Substrat wesentlich vermindert wird und die erwärmte Fläche mittels einer gezielten Druckluftzufuhr oder durch Absaugen von dem Substrat getrennt wird. Die hierzu erzeugte Fluidströmung weist eine Orientierung auf, die nicht parallel zu der Ausnehmung und auch nicht quer zu der Ausnehmung verläuft. Vielmehr schließen die Ausnehmungen und die Fluidströmung jeweils einen spitzen Winkel ein, welcher vorzugsweise zwischen 20° und 40° betragen kann. In der Folge trifft die Luftströmung nicht zugleich auf die Länge der Ausnehmung, sondern nacheinander auf verschiedene Bereiche der Längserstreckung der streifenförmigen Ausnehmung. Hierdurch beginnt die Ablösung der Fläche nicht über die gesamte Erstreckung der Ausnehmung zeitgleich, sondern mit einem zeitlichen Versatz, sodass die Wirkung konzentriert wirkt und zugleich ein Umklappen bereits abgelöster Abschnitte auf noch auf dem Substrat anhaftende Abschnitte vermieden wird.

Dabei ist es von Vorteil, wenn die der Fluidzufuhr abgewandten und/oder der Absaugung zugewandten Bereiche zuerst erwärmt werden, um zu vermeiden, dass Rückstände beim Abtragen vorhergehender Streifen auf hintere Streifen gelangen und deren Abtrag beeinträchtigen können.

Besonders sinnvoll ist es dabei zudem, wenn jeder Bereich durch einen Wärmeeintrag mittels eines Lasers erwärmt wird, indem der Laser relativ zu dem Bereich entlang des streifenförmigen Bereichs von einem ersten Endbereich zu einem dem ersten gegenüberliegenden zweiten Endbereich bewegt wird, wobei der erste Endbereich einen größeren Abstand zu der Fluidzufuhr aufweist als der zweite Endbereich. Die Richtung des entlang einer Linie einwirkenden Wärmeeintrags mittels des Lasers oder einer anderen geeigneten elektromagnetischen Quelle beginnt mit dem der Luftzuführung abgewandten bzw. der Luftabsaugung zugewandten Endbereich des jeweiligen streifenförmigen Bereichs. Hierdurch wird ein unerwünschtes Umklappen bereits abgelöster Abschnitte auf die noch nicht abgelösten Abschnitte desselben Streifens verhindert. Im Falle eines Umklappens können die noch nicht abgelösten Bereiche abgeschattet und deren Erwärmung beeinträchtigt werden.

Die Erfindung lässt verschiedene Ausführungsformen zu. Zur weiteren Verdeutlichung ihres Grundprinzips ist eine davon in der Zeichnung dargestellt und wird nachfolgend beschrieben.
Diese zeigt jeweils in einer Prinzipdarstellung in
- Fig. 1: eine Leiterbahn auf einem Substrat und eine diese einschließende, in streifenförmige Bereiche unterteilte abzutragende Fläche;
- Fig. 2: eine Anordnung zum Entfernen der in Figur 1 gezeigten Bereiche mittels einer Fluidströmung.

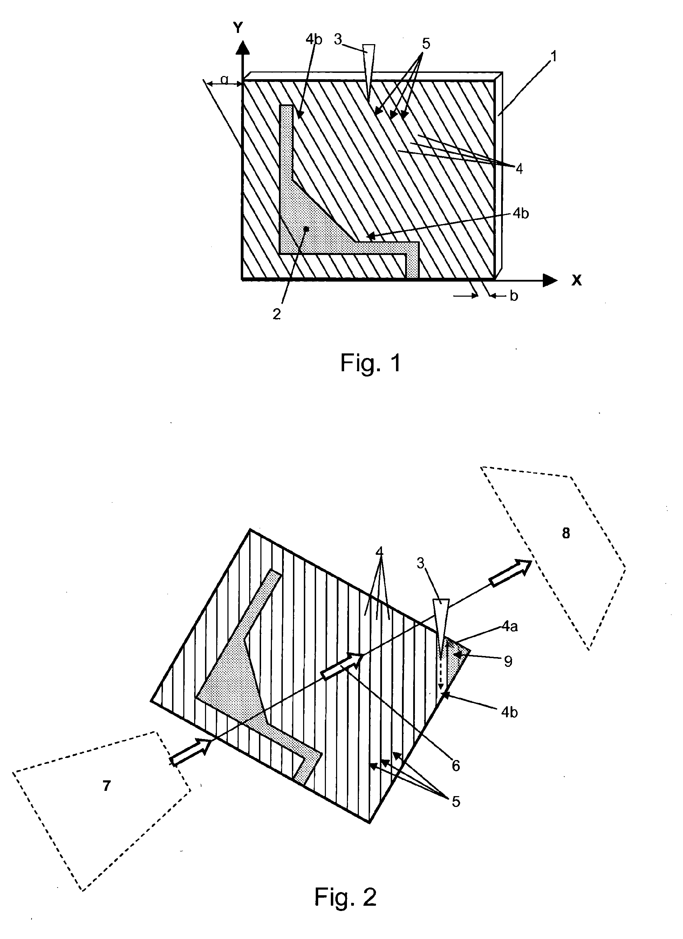

Nachstehend wird anhand der Figuren 1 und 2 das erfindungsgemäße Verfahren zum partiellen Lösen einer definierten Fläche einer leitfähigen Schicht von einem Substrat 1 beschrieben, welche in dem gezeigten Beispiel eine Leiterbahn 2 einschließt. Hierzu wird in dem in Figur 1 gezeigten ersten Verfahrensschritt mittels eines Laserstrahls 3 die Fläche zunächst in Bereiche 4 unterteilt. Hierzu werden die Laserstrahlparameter derart eingestellt, dass lediglich die leitfähige Schicht abgetragen wird, ohne dass dabei zugleich auch das darunterliegende, die leitfähige Schicht tragende Substrat 1 beeinträchtigt wird. Hierzu wird jeder dieser streifenförmigen Bereiche 4 gegenüber den angrenzenden Bereichen 4 der leitfähigen Schicht durch Einbringen einer linienförmigen Ausnehmung 5 entlang eines jeweiligen Umfangs der Bereiche 4 thermisch isoliert. Die Ausnehmungen 5 werden hierzu als im Wesentlichen parallele Geraden eingebracht, die mit den durch den bekannten Verlauf der Leiterbahn 2 bestimmten Hauptachsen X, Y einen spitzen Winkel α von 22,5° einschließen. Auf diese Weise ist in der Praxis ein paralleler Verlauf der Ausnehmungen 5 zu einer Leiterbahn 2 annähernd ausgeschlossen, sodass ein zu der Leiterbahn 2 paralleler thermischer Energieeintrag beim Ablösen des der Leiterbahn 2 benachbarten Bereichs 4 vermieden wird und so eine Schädigung derselben ausgeschlossen ist. Zudem konvergieren die einen jeweiligen Bereich 4 einschließenden Ausnehmungen 5 in den jeweiligen Endbereichen 4a, 4b benachbart zu der Leiterbahn 2, sodass die Breite b des Bereichs 4 in beiden Endbereichen 4a, 4b vermindert ist. Die zum Ablösen erforderliche thermische Energie ist somit ebenfalls reduziert, sodass der thermische Energieeintrag zumindest in dem Endbereich benachbart zu der Leiterbahn 2 vermindert werden kann.

In Figur 2 ist eine Anordnung zum Entfernen der in Figur 1 gezeigten Bereiche 4 mittels einer Fluidströmung 6 gezeigt, bei der zunächst die Orientierung der Fluidströmung 6 relativ zu den Ausnehmungen 5 derart eingestellt wird, dass die Fluidströmung 6 weder parallel noch orthogonal auf die Ausnehmungen 5 trifft. Der Wärmeeintrag zur Reduzierung der Adhäsion der leitfähigen Schicht auf dem Substrat mittels des Laserstrahls 3, dessen Parameter in diesem Verfahrensschritt abweichend eingestellt werden können, erfolgt dabei nicht zugleich über die gesamte Länge des Bereichs 4, sondern punktförmig entlang der Haupterstreckung des Bereichs 4, indem der Laserstrahl 3 relativ zu dem Bereich 4 entlang des streifenförmigen Bereichs 4 von dem ersten Endbereich 4a zu dem zweiten Endbereich 4b bewegt wird. Die Orientierung ist dabei so gewählt, dass der erste Endbereich 4a einen größeren Abstand zu einer durch Druckluft realisierten Fluidzufuhr 7 aufweist als der zweite Endbereich 4b bzw. der erste Endbereich 4a einen geringeren Abstand zu einer Absaugung 8 aufweist als der zweite Endbereich 4b. Es erfolgt somit ein partieller, mit der Relativbewegung des Laserstrahls 3 voranschreitender Abtrag der leitfähigen Schicht, wobei die genannte Orientierung dazu führt, dass ein unerwünschtes Umklappen bereits abgelöster Abschnitte 9 auf die noch nicht abgelösten Abschnitte desselben Bereichs 4 verhindert wird. Im Falle eines Umklappens könnten anderenfalls die noch nicht abgelösten Abschnitte abgeschattet und deren Erwärmung beeinträchtigt werden. Das Ablösen der einzelnen Bereiche 4 erfolgt nacheinander, wobei die der Fluidzufuhr 7 abgewandten und/oder der Absaugung 8 zugewandten Bereiche 4 zuerst erwärmt werden, sodass die abgelösten Partikel der leitfähigen Schicht sich nicht auf den noch in Richtung der Fluidströmung 6 dahinterliegenden Bereichen 4 niederschlagen und deren Erwärmung beeinträchtigen können.

## Patentansprüche

1. Verfahren zum partiellen Lösen einer definierten Fläche einer leitfähigen Schicht mittels eines Laserstrahls (3), wobei auf einem Substrat eine Leiterbahn (2) mit einem bestimmten Verlauf aus der leitfähigen Schicht ausgebildet wird und wobei die Laserstrahlparameter derart eingestellt werden, dass lediglich die leitfähige Schicht abgetragen wird, ohne dass dabei zugleich auch das darunterliegende, die leitfähige Schicht tragende Substrat (1) beeinträchtigt wird, wobei die Fläche zunächst in Bereiche (4) unterteilt wird, die jeweils in ihrem äußeren Randbereich gegenüber den angrenzenden Bereichen (4) der leitfähigen Schicht durch Einbringen einer linienförmigen Ausnehmung (5) entlang eines jeweiligen Umfangs der Bereiche (4) thermisch isoliert werden, und anschließend ein abzutragender Bereich (4) mittels Laserstrahlung erwärmt wird, bis die Adhäsion der leitfähigen Schicht auf dem Substrat (1) wesentlich verringert ist und der abzutragende Bereich (4) von dem Substrat (1) unter äußeren Einwirkungen flächig abgelöst wird, **dadurch gekennzeichnet, dass** die Bereiche (4) streifenförmig ausgebildet werden, sodass die Ausnehmungen (5) entlang von Geraden verlaufen, deren Verlauf so gewählt wird, dass *die Geraden stets in einem spitzen Winkel auf die Leiterbahn treffen, so dass sie* zu keiner der durch den bekannten Verlauf der Leiterbahn (2) bestimmten Hauptachsen (X, Y) parallel verlaufen.

2. Verfahren nach Anspruch 1, **dadurch gekennzeichnet, dass** die Ausnehmungen (5) sowohl mit den Hauptachsen (X, Y) als auch mit den Winkelhalbierenden der Hauptachsen (X, Y) einen spitzen Winkel (α) einschließen.

3. Verfahren nach den Ansprüchen 1 oder 2, **dadurch gekennzeichnet, dass** die Ausnehmungen in einem Winkel (α) zwischen 10° und 35°, insbesondere zwischen 20° und 25°, zu einer Hauptachse (X, Y) verlaufen.

4. Verfahren nach zumindest einem der vorhergehenden Ansprüche, **dadurch gekennzeichnet, dass** die Ausnehmungen (5) eines Bereichs (4) mit Ausnahme der jeweiligen Endbereiche (4a, 4b) parallel zueinander verlaufen.

5. Verfahren nach zumindest einem der vorhergehenden Ansprüche, **dadurch gekennzeichnet, dass** die Ausnehmungen (5) in einem zu der Leiterbahn (2) benachbarten Endbereich (4a, 4b) mit einer der Leiterbahn (2) zugewandten Abwinkelung und/oder Biegung in einem Winkel von insbesondere 90° zu der Leiterbahn eingebracht werden.

6. Verfahren nach zumindest einem der vorhergehenden Ansprüche, **dadurch gekennzeichnet, dass** die Bereiche (4) mittels einer gezielten Fluidströmung (6) durch eine Fluidzufuhr (7), insbesondere Druckluftzufuhr, und/oder durch Absaugen mittels einer Absaugung (8) von dem Substrat (1) getrennt werden.

7. Verfahren nach Anspruch 6, **dadurch gekennzeichnet, dass** die Richtung der Fluidströmung (6) derart eingestellt wird, dass diese zu den geraden Ausnehmungen (5) weder parallel noch orthogonal verläuft.

8. Verfahren nach Anspruch 6 oder 7, **dadurch gekennzeichnet, dass** die der Fluidzufuhr (7) abgewandten und/oder der Absaugung (8) zugewandten Bereiche (4) zuerst erwärmt werden.

9. Verfahren nach zumindest einem der Ansprüche 6 bis 8, **dadurch gekennzeichnet, dass** jeder Bereich (4) durch einen Wärmeeintrag mittels eines Laserstrahls (3) erwärmt wird, indem der Laserstrahl (3) relativ zu dem Bereich (4) entlang des streifenförmigen Bereichs (4) von einem ersten Endbereich (4a) zu einem dem ersten gegenüberliegenden zweiten Endbereich (4b) bewegt wird, wobei der erste Endbereich (4a) einen größeren Abstand zu der Fluidzufuhr (7) aufweist als der zweite Endbereich (4b).

10. Verfahren nach zumindest einem Ansprüche 6 bis 9, **dadurch gekennzeichnet, dass** die Bereiche (4) derart in einzelne Streifen unterteilt werden, dass die Ausnehmungen (5) entlang paralleler Geraden verlaufen.

## Claims

1. Method for partially stripping a defined area of a conductive layer by means of a laser beam (3), wherein a conductor track (2) with a defined path is formed from the conductive layer on a substrate and wherein the laser beam parameters are set in such a way that only the conductive layer is removed, without the underlying substrate (1), carrying the conductive layer, also being impaired at the same time, wherein the area is initially divided into regions (4), which are respectively thermally insulated in their outer peripheral region with respect to the adjoining regions (4) of the conductive layer by introducing a linear recess (5) along a respective periphery of the regions (4), and subsequently a region (4) to be removed is heated by means of laser radiation until the adhesion of the conductive layer on the substrate (1) is significantly reduced and the region (4) to be removed is detached over its surface area from the substrate (1) under external effects, **characterized in that** the regions (4) are formed as strips, so that the recesses (5) extend along straight lines, the path of which is chosen such that the straight lines always meet the conductor track at an acute angle, so that they do not extend parallel to any of the main axes (X, Y) determined by the known path of the conductor track (2).

2. Method according to Claim 1, **characterized in that** the recesses (5) enclose an acute angle (α) both in relation to the main axes (X, Y) and in relation to angle bisectors of the main axes (X, Y).

3. Method according to Claim 1 or 2, **characterized in that** the recesses extend at an angle (α) of between 10° and 35°, in particular between 20° and 25°, in relation to one of the main axes (X, Y).

4. Method according to at least one of the preceding claims, **characterized in that** the recesses (5) of a region (4) extend parallel to one another with the exception of the respective end regions (4a, 4b).

5. Method according to at least one of the preceding claims, **characterized in that**, in an end region (4a, 4b) adjacent to the conductor track (2), the recesses (5) are incorporated with an angling and/or bending towards the conductor track (2) at an angle of in particular 90° in relation to the conductor track.

6. Method according to at least one of the preceding claims, **characterized in that** the regions (4) are separated from the substrate (1) by means of a targeted fluid flow (6) by a fluid supply (7), in particular a compressed-air supply, and/or by suction by means of a suction system (8).

7. Method according to Claim 6, **characterized in that** the direction of the fluid flow (6) is set in such a way that it extends neither parallel nor orthogonal to the straight recesses (5).

8. Method according to Claim 6 or 7, **characterized in that** the regions (4) remote from the fluid supply (7) and/or close to the suction system (8) are heated first.

9. Method according to at least one of Claims 6 to 8, **characterized in that** each region (4) is heated by heat input by means of a laser beam (3), **in that** the laser beam (3) is moved relative to the region (4) along the strip-shaped region (4) from a first end region (4a) to a second end region (4b) opposite from the first end region, the first end region (4a) being at a greater distance from the fluid supply (7) than the second end region (4b).

10. Method according to at least one of Claims 6 to 9, **characterized in that** the regions (4) are divided into individual strips in such a way that the recesses (5) extend along parallel straight lines.

## Revendications

1. Procédé de détachement partiel d'une surface définie d'une couche conductrice au moyen d'un rayon laser (3), une piste conductrice (2) ayant une certaine orientation étant constituée sur un substrat à partir de la couche conductrice et les paramètres du rayon laser étant définis de manière à ce que seule la couche conductrice soit érodée sans affecter alors en même temps aussi le substrat sous-jacent (1) supportant la couche conductrice, la surface étant d'abord divisée en zones (4) qui sont isolées respectivement du point de vue thermique, sur leur périphérie extérieure, des zones adjacentes (4) de la couche conductrice en y pratiquant une échancrure de forme linéaire (5) le long d'une circonférence respective des zones (4) puis une zone à éroder (4) étant chauffée au moyen d'un rayonnement laser jusqu'à ce que l'adhérence de la couche conductrice sur le substrat (1) soit sensiblement réduite et que la zone à éroder (4) soit détachée du substrat (1) au niveau de sa surface sous intervention extérieure, **caractérisé en ce que** les zones (4) sont réalisées en forme de bandes de telle sorte que les échancrures (5) s'étendent suivant des droites dont l'orientation est choisie de manière à ce que ces droites arrivent toujours sur la piste conductrice en angle aigu, de sorte qu'elles ne s'étendent parallèlement à aucun des axes principaux (X, Y) définis par l'orientation connue de la piste conductrice (2).

2. Procédé selon la revendication 1, **caractérisé en ce que** les échancrures (5) circonscrivent un angle aigu (α) aussi bien avec les axes principaux (X, Y) qu'avec les bissectrices des axes principaux (X, Y).

3. Procédé selon la revendication 1 ou 2, **caractérisé en ce que** les échancrures s'étendent suivant un angle (α) compris entre 10° et 35°, en particulier entre 20° et 25°, par rapport à un axe principal (X, Y).

4. Procédé selon au moins une des revendications précédentes, **caractérisé en ce que** les échancrures (5) d'une zone (4), à l'exception des extrémités respectives (4a, 4b), s'étendent parallèlement les unes aux autres.

5. Procédé selon au moins une des revendications précédentes, **caractérisé en ce que** les échancrures (5) sont pratiquées dans une extrémité (4a, 4b) voisine de la piste conductrice (2) avec un angle tourné vers la piste conductrice (2) et/ou une courbure suivant un angle en particulier de 90° par rapport à la piste conductrice.

6. Procédé selon au moins une des revendications précédentes, **caractérisé en ce que** les zones (4) sont séparées au moyen d'un écoulement dirigé de fluide (6) par une alimentation en fluide (7), en particulier une alimentation en air comprimé, et/ou par aspiration du substrat (1) au moyen d'un système d'aspiration (8).

7. Procédé selon la revendication 6, **caractérisé en ce que** le sens de l'écoulement de fluide (6) est défini de manière à n'être orienté ni parallèlement, ni orthogonalement par rapport aux échancrures droites (5).

8. Procédé selon la revendication 6 ou 7, **caractérisé en ce que** les zones (4) tournées à l'écart de l'alimentation en fluide (7) et/ou vers le système d'aspiration (8) sont d'abord chauffées.

9. Procédé selon au moins une des revendications 6 à 8, **caractérisé en ce que** chaque zone (4) est chauffée par apport thermique au moyen d'un rayon laser (3) en déplaçant le rayon laser (3) par rapport à la zone (4) le long de la zone en forme de bande (4) d'une première extrémité (4a) à une seconde extrémité (4b) opposée à la première, la première extrémité (4a) étant plus éloignée de l'alimentation en fluide (7) que la seconde extrémité (4b).

10. Procédé selon au moins une des revendications 6 à 9, **caractérisé en ce que** les zones (4) sont divisées en bandes distinctes de manière à ce que les échancrures (5) soient orientées suivant des droites parallèles.
